Europäisches Patentamt

(19) European Patent Office

Office européen des brevets

(11) Publication number: **0 158 437**
**A2**

## (12) EUROPEAN PATENT APPLICATION

(21) Application number: **85301525.3**

(22) Date of filing: **06.03.85**

(51) Int. Cl.⁴: **H 01 R 43/00**
**H 05 K 13/00**

(30) Priority: **06.04.84 US 597637**

(43) Date of publication of application:
**16.10.85 Bulletin 85/42**

(84) Designated Contracting States:
**CH DE FR GB IT LI NL**

(71) Applicant: **MOLEX INCORPORATED**
**2222 Wellington Court**
**Lisle Illinois 60532(US)**

(72) Inventor: **Olson, Thor**
**1613 Groton Ct.**
**Wheaton Illinois 60187(US)**

(74) Representative: **Slight, Geoffrey Charles et al,**
**Graham Watt & Co. Riverhead**
**Sevenoaks Kent TN13 2BN(GB)**

(54) **Method and apparatus for handling solid members having spaced apart pin-like projections; and assemblies of such members.**

(57) Electrical connectors (12) having pin conductors (18) are mounted on a flexible support sheet (14) by puncturing the pins through the sheet. Packaging is accomplished by folding the sheet (14) in a stack (80) and inserting the stack in a container (82). The connectors (12) may be cut into smaller connectors while mounted on the sheet (14). The connectors, while still mounted on the sheet (14), may be dispensed to a work station where they may be plucked from the sheet, e.g. by a robot arm for assembly in an electrical appliance.

FIG.1

FIG. 2

EP 0 158 437 A2

METHOD AND APPARATUS FOR HANDLING SOLID
MEMBERS HAVING SPACED APART PIN-LIKE
PROJECTIONS; AND ASSEMBLIES OF SUCH MEMBERS.

The present invention relates to method and apparatus for handling solid members having spaced apart pin-like projections; and assemblies of such members.

The invention will be described with reference to handling electrical connectors in particular, by way of example but is not restricted to handling electrical connectors.

The handling may involve manufacturing and/or packaging and/or transporting the solid members as well as presenting the solid members for use in assembly operations and the invention includes, as an article of manufacture, an assembly of such solid members.

Electrical connectors are mass produced by positioning an insulative housing, generally a plastic rectangularly shaped member, automatically at various locations along an assembly line for pin insertion and other machine accomplished steps until the electrical connector is in its final manufactured form. Once the electrical connector is completed, the connectors are automatically conveyed to a completed connector hopper positioned to receive the connectors from a conveyor so that the completed connectors fall one by one into the hopper where they fall upon each other. The completed connectors falling upon each other sometimes cause damage to the extending pins or conductors such as by causing some of the plated-on highly conductive metal to be scraped away from the conductors or pins or by bending the pins.

The connectors are manually removed from the hopper, one by one, inspected and manually packaged. Packaging the connectors can be done in bulk by filling a plastic bag or other suitable container with a number of connectors in contact with each other in a random manner, but bulk packaging generally is unsuitable because many of the connectors are damaged during transport. Another more time consuming and expensive method of packaging connectors has been by manually aligning the connectors in layers in a suitable container, such as a cardboard box, to minimize the connector contact during storage. A layer of compressible material sometimes is disposed between each layer of hand packed connectors to minimize the damage to the connectors during transport.

Recently, the applicant has packaged connectors by aligning the connectors longitudinally in plastic tubes so that the connectors come into contact with each other only at plastic housing ends so that the conductors or pins extending from the connector housings do not contact each other during transport.

Another prior art method of packaging connectors has been to provide individual support trays having individual recesses shaped generally to conform to the profile configuration of an individual connector so that each connector is packaged in its own individual recess of a tray and a compressible sheet of material can be layered over the tray to minimize the possibility of the packaged connectors contacting each other during transport. This method of packaging, of course, is extremely expensive, requires a great amount of packaging space to package a small number of connectors, and each connector must be manually packed.

It is believed that some electrical circuit elements, such as transistors, have been packaged by inserting the extending conductors into a rigid foam block, such as styrofoam, in a single layer requiring a massive amount of packaging space for only a few circuit elements. For shipment, the layer of circuit elements must be held into the styrofoam block with a contacting pressure layer of packaging material to prevent the circuit elements from falling out of the styrofoam during transport.

In brief, the present invention provides from one aspect for packaging a plurality of electrical connectors on a flexible support sheet by inserting the extending conductors of each electrical connector into the surface of the flexible support sheet to removably retain the electrical conductors onto the flexible support sheet and thereby manufacture a flexible substrate assembly. The methods, apparatus, and articles of manufacture disclosed herein are applicable to any solid member having rigid extending projections, such as electrical connectors.

In accordance with a further aspect of the present invention, a plurality of solid members having extending rigid projections are removably retained in a predetermined disposition on a flexible support substrate to form a flexible substrate assembly by disposing one of the solid members in juxtaposition to the support substrate such that the projections of the one solid member extend toward a surface of the substrate and then forcing the one solid member toward the substrate surface to insert the projections into the substrate surface thereby forming projection retaining apertures in the substrate surface defined by a substrate surface configuration surrounding the inserted projections, and to removably retain the one solid member on the substrate. A second solid member then is disposed in juxtaposition to the substrate such that the projections of the second solid member extend toward the substrate. The second solid member then is forced toward the flexible substrate to contact the substrate surface with the projections of the second solid member and to insert the projections of the second solid member into the substrate surface and to removably retain the second solid member on the substrate at a predetermined location with respect to the one solid member. In a preferred embodiment, the solid members are electrical connectors having an insulative housing and a plurality of rigid electrical conductors extending outwardly from the housing.

The flexible substrate permits e.g. the packaging of a plurality of connectors in a stacked array by disposing one of the electrical connectors in juxtaposition to a flat flexible support substrate portion at a work station such that the conductors of the one electrical connector are essentially perpendicular to a surface of the flexible substrate, forcing the one electrical connector toward the substrate surface to insert the conductors into the substrate surface thereby forming conductor retaining apertures in the substrate surface defined by a substrate surface configuration surrounding the inserted conductors, and to removably retain the one electrical connector on the substrate; moving the substrate so that the solid member is moved away from the work station and another flat substrate portion is provided at the work station; disposing a second electrical connector in juxtaposition to the substrate such that the conductors of the second electrical connector are essentially perpendicular to the other substrate surface portion; forcing the second electrical connector toward the substrate to insert the conductors of the second electrical connector into the substrate surface and to removably retain the second electrical connector on the substrate at a predetermined location with respect to the one electrical connector; and repeating the solid member insertion steps until a desired number of solid members are inserted into the substrate.

The flexible substrate assembly can be bent to stack the substrate assembly upon itself to provide a plurality of connectors removably retained on the flexible substrate in a stacked array.

Thus, the substrate assembly can be stacked by winding the substrate and retained connectors upon each other in reel form to provide an annular array of connectors retained in and spaced by the flexible substrate.

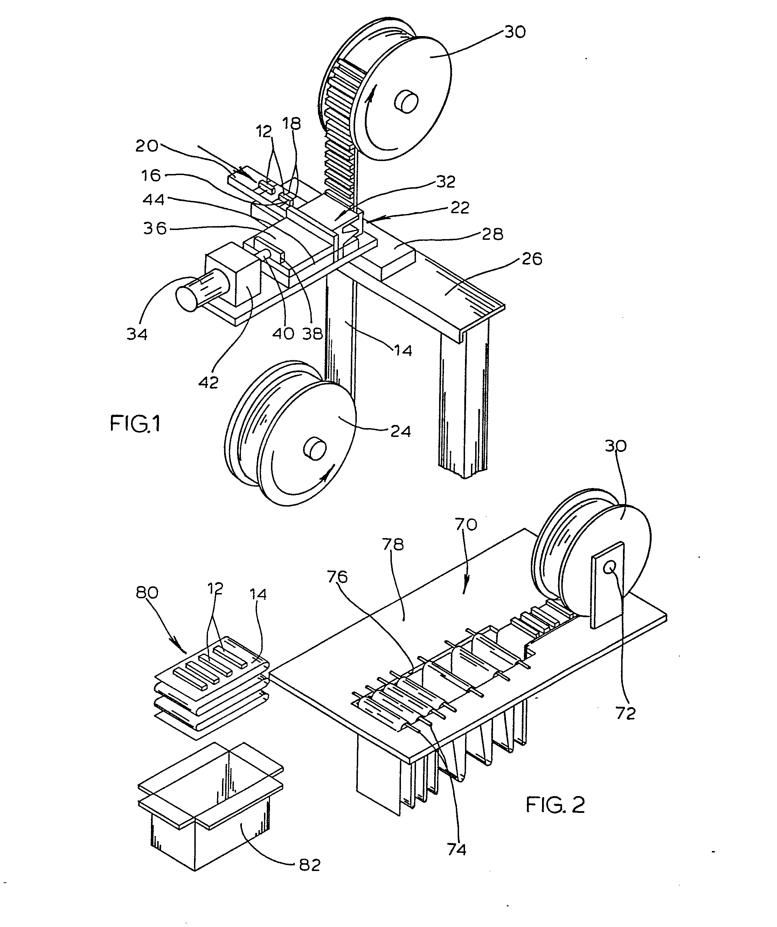

Alternatively, the substrate assembly, including the plurality of connectors retained on the flexible substrate, can be stacked by folding the substrate upon itself in a boustrophedon pattern (see Fig. 2), to fold one layer of substrate and retained connectors upon another layer of substrate and retained connectors.

The connectors can be spaced on the flexible substrate such that the substrate can be folded in a boustrophedon pattern to provide an intermediate layer of flexible substrate between adjacent stacked layers of connectors.

A plurality of stacked arrays of flexible substrate retained connectors (substrate assemblies) can be disposed in a single container for transport.

In order to minimize packaging space requirements and to prevent connector contact during transport, the connectors are conveniently inserted into the flexible substrate such that the longitudinal axes of adjacent connectors are disposed substantially parallel.

A flexible substrate assembly of the present invention includes an elongated sheet of flexible sheet material having removably retained thereon in a predetermined disposition, one to another, a plurality of solid members or electrical connectors each having a plurality of extending rigid projections or electrical conductors, the projections extending into and being removable from the flexible sheet material.

A first plurality of solid members may be held on the flexible substrate in longitudinal alignment and a second plurality of longitudinally aligned solid members may be held on the flexible substrate in a disposition transversely spaced from the first plurality of solid members.

Each plurality of solid members in longitudinal alignment will contact each other only at the ends of the solid members so that no functional damage occurs to the projections during transport.

The flexible substrate assemblies can be stacked by bending the flexible substrate upon itself to provide a plurality of solid members removably retained on a continuous flexible substrate in a stacked array, such as by winding the substrate on a reel or folding the substrate upon itself in a boustrophedon pattern.

In accordance with another aspect of the present invention, in a method of manufacturing electrical connectors, a plurality of electrical connectors can be cut to a predetermined length from a longer electrical connector by disposing the longer electrical connector in juxtaposition to a flexible support substrate such that the conductors of the longer connector are essentially perpendicular to a surface of the flexible substrate; forcing the longer electrical conductor toward the substrate surface to insert the conductors into the substrate surface and to removably retain the longer electrical connector on the substrate; and cutting the longer electrical connector, while the longer electrical connector is retained on the substrate, to form a plurality of electrical connectors of predetermined length, each of the plurality of connectors having a plurality of extending conductors inserted in the substrate surface.

A plurality of electrical connectors can be cut into smaller electrical connectors of predetermined length in this manner while the plurality of electrical connectors are removably retained on the flexible support substrate, particularly by cutting the longer electrical connectors in a direction transverse to the longitudinal axis of the longer electrical connectors while the connectors are retained on the flexible substrate.

To prevent warping of the cut connectors due to axial stress of simultaneous, multiple cutting blades, when a longer electrical connector is cut in more than one transverse location, it is preferred that the plurality of cuts are made sequentially so that the longer electrical connector is not cut twice simultaneously.

The plurality of electrical connectors may be disposed in the substrate such that longitudinal axes are essentially parallel at a predetermined transverse spacing between transversely adjacent longer electrical connectors to provide predetermined spaced cutting stations adjacent a plurality of spaced reciprocable cutting blades. In this manner, a plurality of transversely spaced connectors can be cut into smaller electrical connectors simultaneously.

A plurality of cuts can be made simultaneously, one in each of a plurality of spaced connectors, with a cutting means having a plurality of blades spaced from each other both longitudinally and transversely to provide a single cut in each of the plurality of electrical connectors while cutting the plurality of connectors simultaneously. The connectors may be cut to a predetermined size by conveying the plurality of longer electrical connectors spaced and retained on the flexible substrate in a direction transverse to the longitudinal axes of the longer electrical connectors to dispose each of the longer electrical connectors in alignment with a cutting blade.

A packaging arrangement can be produced by folding a substrate assembly of the present invention into a substrate assembly opening in a container. The container opening then is closed for transport of the packaging arrangement.

The flexible sheet material may comprise a plurality of interconnected film or sheet layers contacting the rigid connector projections or conductors at a plurality of spaced locations to prevent the connectors from inadvertent removal from the sheet material when the sheet material is moved. Such layers of the flexible sheet material can be, for example, gaseously spaced layers of foamed polymeric material such as a foamed polyolefin, e.g. foamed polyethylene.

According to a further aspect of the present invention, apparatus is provided for manufacturing a flexible substrate assembly including a work station where a plurality of solid members having a plurality of spaced-apart, parallel pin-lik projections extending therefrom are mounted on a sheet of flexible sheet material. A continuous source of sheet material is provided to the work station, such as from a sheet material reel. The sheet material is moved longitudinally such as by a motor to dispose a predetermined portion of the sheet material, at the work station. Loading apparatus is provided to present a plurality of solid members, one at a time, to the work station, and apparatus is provided to move each solid member with respect to the sheet material to sequentially mount the solid members into the sheet material, with longitudinal sheet material movement after each solid member insertion to dispose a different portion of the sheet material at the work station for insertion of another solid member.

The present invention still further provides apparatus for disposing an electrical connector at a predetermined disposition relative to a work station including a housing for containing a stacked array of electrical connectors removably retained in a flexible sheet material, the connectors having extending rigid projections inserted into the flexible sheet material; and a sheet material support platform extending from the housing. The support platform has a first end contacting the housing and a second end disposed at a predetermined disposition relative to the work station. A continuous web of flexible sheet material having a plurality of connectors retained thereon, disposed in a stacked array in the housing, is positioned to extend from the housing over the sheet material support platform to expose the connectors above the sheet material on the support platform for removal of the connectors from the sheet material at the work station.

Flexible sheet material holding apparatus may be provided for holding the flexible sheet material against the support platform when a connector is removed from the sheet material.

The sheet material holding apparatus may include a spring disposed to bias the sheet material against the container or hopper carrying the sheet material retained connectors.

Specific embodiments of the present invention in all its various aspects will now be described in detail by way of example, and not by way of limitation, with reference to drawings in which:-

FIG. 1 is a perspective view of a method and apparatus for inserting electrical connectors into a flexible sheet material in accordance with the present invention;

FIG. 2 is a perspective view showing a flexible substrate and inserted connectors of the present invention being festooned or folded to package a continuous web of substrate and retained connectors in rectangular form for transport in accordance with a method of the present invention;

FIGS. 3 to 6 are side views of a connector insertion station portion of the method and apparatus of Fig. 1, showing insertion of a connector into a flexible support sheet;

FIG. 7 is an enlarged partially broken away perspective view of an apparatus of the present invention showing a flexible sheet support roller and sheet hold-down spring for disposing connectors, one at a time, at a work station;

FIG. 8 is a partially broken away side view of the apparatus of Fig. 7 showing the disposition of an electrical connector at a work station from a packaged continuous web of flexible sheet material and inserted connectors, packaged in festooned or folded form in accordance with the present invention;

FIG. 9 is a partially broken away side view of a cutting blade assembly for cutting a connector into a plurality of smaller connectors while retained on a flexible support sheet in a method of the present invention;

FIG. 10 is a perspective view of the cutting blade assembly of Fig. 9 showing the cutting sequence of a plurality of longitudinally and transversely spaced blades; and

FIG. 11 is a perspective view of a sheet material support platform and sheet material hold-down spring attached to a sheet material container, in an apparatus constructed in accordance with the principles of the present invention.

Turning now to the drawings and initially to Figs. 1 and 3 to 6, there is illustrated a plurality of electrical connectors 12 inserted into a sheet or web of flexible polymeric material 14. The electrical connectors 12 include an insulative housing 16 having a plurality of electrically conductive pins 18 extending from the housing 16. It is understood, however, that the principles of the present invention are equally applicable to any solid member having rigid projections extending therefrom, such as other electrical circuit members.

As shown in Fig. 1, completed electrical connectors 12 are conveyed along a conveyor platform 20 in single file longitudinal alignment to an insertion station, generally designated 22. En route to the insertion station 22, for example along the connector conveyor platform 20, the connectors 12 can be manually or mechanically inspected for conductor damage, for example by laser or sonic inspection prior to insertion into the polymeric sheet material 14.

The sheet or web of flexible polymeric material 14 is supplied at the insertion station 22 from a sheet material supply roll 24 and passes vertically upwardly through conveyor support platform 26 and conveyor support bar 28. The completed connectors 12 conveyed along the completed connector conveyor platform 20 are conveyed to the insertion station 22 in alignment, one at a time, with the continuous sheet or web of flexible polymeric material 14 where each completed connector 12 is sequentially inserted into the sheet material 14. The completed connectors 12 are conveyed to the insertion station 22 in alignment with the sheet material 14 such that a plurality of electrically conductive pins 18 extending from the connector insulative housings 16 are disposed substantially perpendicular to a surface of the polymeric sheet material 14, as shown in Figs. 1 and 3 to 6. A packaged connector take-up reel 30 is disposed above the insertion station 22 and is automatically rotated at a predetermined speed by a suitable motor (not shown) to wind the packaged connectors 12 retained on the flexible support sheet 14 onto the reel 30 at a predetermined transverse spacing between longitudinally parallel connectors 12.

The flexible support material 14 is non-rigid in the sense that it can receive and grip the pins 18. Thus, it has been found that non-rigid support sheets 14 are able to grasp inserted rigid projections, such as connector pins 18, relatively tightly. Further, the holes or apertures made by the pins 18 upon insertion into the flexible sheet material 14 do not enlarge when the flexible material and inserted connectors are moved or vibrated during transport because of the pliable nature of flexible sheet or foam materials.

Rigid materials, such as rigid foam material, will permanently distort to enlarge pin receiving apertures if force is applied by inserted pins against the rigid foam material surrounding and defining the pin receiving apertures. Rigid material capable of pin-receiving aperture enlargement during transport is not suitable as a connector packaging support material since a great many of the connectors would separate from the support material during transport.

Any flexible or semi-rigid but pliable tape, sheet or web of polymeric material in solid or foam form are suitable as the flexible support material 14. Suitable flexible polymeric support materials include: the polyolefins, such as polyethylene and polypropylene in solid or foamed form; any of the flexible solid and foam materials manufactured from elastomeric resins so long as they are capable of being punctured by the rigid conductors of a connector; cast or extruded films or sheets of acrylics, such as polyacrylates, polymethacrylates and copolymers thereof; cellulose acetate; cellulose triacetate; other cellulosics from solution or dispersion; polytetrafluoroethylenes; polycarbonates; polyethersulfone; polyethylene terephthalate; polyimides; polyvinyl alcohol; polyvinyls, polyvinyl chloride and vinyl copolymers; ethylene-vinyl acetate; polyethylene oxide and polyurethane so long as the sheets or webs 14 are non-rigid and capable of being punctured by the extending rigid conductors or pins 18 of a connector 12. Suitable flexible sheet material is for example 1/32 to 1/2 inch thick. Foam material having a thickness of about 1/16 inch provides effective retention of the connectors 12 while not occupying excessive packaging space. The sheet material should not be so thick that penetration of pins 18 will cause the pins 18 to bend. The flexible sheets or webs 14 useful in carrying out the present invention can have a relatively dense and rigid surface skin so long as the flexible sheet 14 is non-rigid at its center or core since the core of the flexible sheet material 14 will remain pliable to grasp and retain inserted pins 18.

Flexible foam materials are particularly well adapted for retaining inserted pins 18 particularly the closed cell foams or partly open cell foams. Flexible foam support materials 14 include multiple spaced films of polymeric material capable of self healing punctures made therein and therefor or firmly grasping the inserted pins 18 at spaced locations to provide good retention of the connector on the flexible material, yet allowing the connector 12 to be removed with a relatively small force perpendicular to the surface of the foam sheet material. The closed cell and partly open cell foams will provide more resistance to penetration of pins 18 resulting from increased pressure within the closed cells as the pins 18 attempt to penetrate the closed cells. This increased resistance causes the polymeric cell material to stretch somewhat to provide more gripping polymeric material in the immediate area of pin penetration to grip the pins 18 more tightly once penetration occurs. The open cell foams also provide a polymeric material stretching advantage to provide for greater retention but to a lesser extent. Rigid foams such as rigid epoxys and rigid polyesters are not suitable as the support sheet 14 since the pin receiving apertures will enlarge during transport and many of the connectors 12 will separate from the foam material.

Referring again to the drawings, the insertion station, generally designated 22, includes a connector insertion bar, generally designated 32, operatively connected to an hydraulic piston and cylinder assemblage 34. The connector insertion bar 32 is operatively connected to the assemblage 34 through insertion bar slide plate 36, piston support bar 38 and piston rod 40. The piston rod 40 passes through an annular alignment aperture (not shown) in hydraulic cylinder support block 42. As shown in Figs. 1 and 3 to 6, the connector insertion bar 32 and the insertion bar slide plate 36 slide toward and away from the polymeric sheet material 14 on support plate 44 for insertion of the extending pins 18 of completed connectors 12 into the surface of the flexible polymeric sheet material 14.

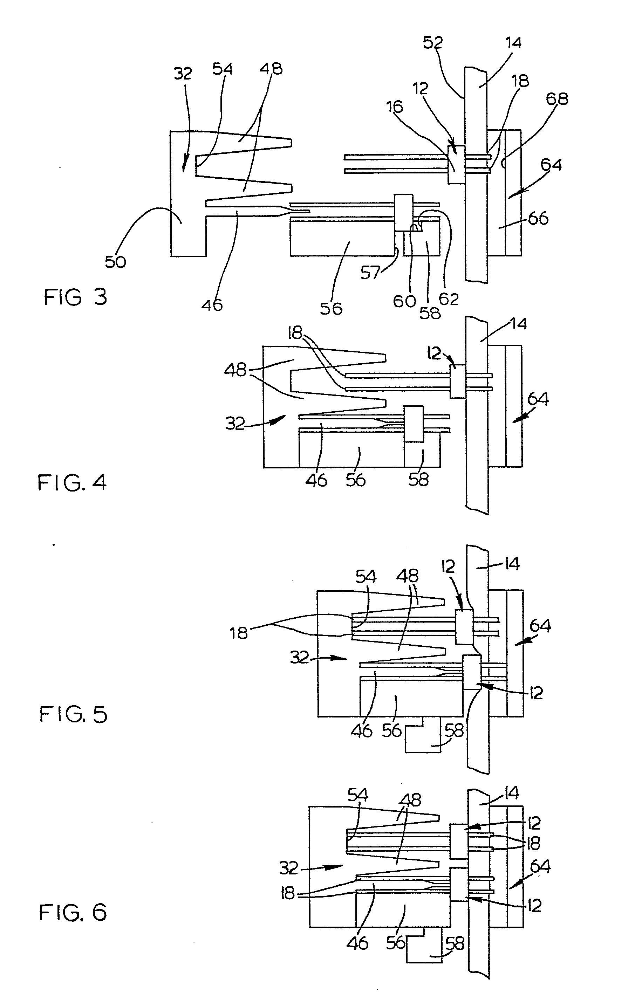

The connector insertion bar 32 includes an elongated insertion plate 46 for forcing the extending pins 18 of individual connectors 12 against the polymeric sheet material 14. As shown in detail in Figs. 3 to 6, the insertion plate 46 forces the extending pins 18 into the flexible polymeric sheet material 14 to retain the connectors 12 on the flexible sheet material 14. The connector insertion bar 32 also includes a pair of integral spaced alignment plates 48 for maintaining a substantially perpendicular alignment of an inserted connector 12 adjacent to a connector 12 being inserted. The pair of alignment plates 48, like the insertion plate 46, extend outwardly from an insertion bar base 50 in a direction perpendicular to a major surface 52 of the flexible polymeric support sheet 14. The pair of alignment plates 48 are spaced a predetermined distance at the insertion bar base 50 to provide an elongated slot 54 at the base 50 so that the conductive pins 18 of the electrical connectors 12 fit between the pair of alignment plates 48 to contact the base wall of the elongated slot 54. In this manner, as best shown in Fig. 5, the pins 18 of an inserted connector 12 are retained between the pair of alignment plates 48 to maintain the inserted connector 12 in substantially perpendicular alignment with respect to the major surface 52 of the polymeric sheet material 14 while an adjacent next lower connector 12 is inserted into the polymeric sheet material 14.

The insertion station 22 includes a horizontally reciprocable connector pin support bar 56, having a forward stop wall 57, and an adjacent elongated, L-shaped vertically reciprocable connector housing support bar 58 to define an elongated rectangular connector housing support slot 60 for receiving and supporting the insulative housings 16 of connectors 12. The elongated, L-shaped vertically reciprocable connector support bar 58 includes a vertical connector housing stop wall 62 to prevent movement of the connector 12 toward the major surface 52 of the polymeric support material 14 after the connector pin support bar 56 is moved forwardly to contact stop wall 57 with the connector 12 and move the connector against connector support bar stop surface 62. The L-shaped vertically movable connector support bar 58 must be moved vertically downwardly, as shown in Fig. 5, to permit the connector insertion plate 46 to force the connector 12 in a direction toward the flexible polymeric sheet material 14 for insertion of the electrically conductive pins 18 of the connector 12 into the flexible polymeric sheet material 14. When the connector contacting insertion bar 32 retracts to the position shown in Fig. 3, after insertion of a connector 12, the L-shaped vertically movable connector support bar 58 retracts vertically upwardly to the position shown in Fig. 3 to receive another conveyed connector 12 in the elongated rectangular housing support slot 60. The insertion steps then can be repeated for insertion of another connector 12 into the flexible polymeric sheet material 14.

It has been found that by inserting a plurality of connectors in an aligned, relatively dense array on the flat, flexible sheet material 14, it is relatively easy to detect defects in the upwardly extending conductors or pins 18. The relative density of the upstanding pins 18 when a number of connectors are aligned on the sheet material 14 provides for easy detection of a bent or missing pin and for tarnished or discoloured conductive pin plating. The damaged connectors can be easily removed from the flexible support sheet 14 and replaced.

Further, the connectors can be inserted onto the sheet material in spaced groups of rows to provide for quick assessment of the number of connectors packaged. For example, the connectors can be inserted into the flexible sheet material 14 in relatively closely spaced groups of n rows followed by an optically recognizable wider space, followed by another relatively closely spaced group of n more rows, and so on. The number of groups of n connectors can be easily counted to determine the total number of packaged connectors.

As shown in Figs. 3 to 6, the insertion station 22 also includes an insertion station sheet material support plate generally designated 64 vertically disposed behind the flexible sheet material 14. The support plate 64 includes a rigid pin receivable layer 66 adhered to its sheet material facing surface 68.

The completed, substrate assembly is wound onto take-up reel 30. The packaged connectors 12 inserted into the flexible polymeric material 14 on take-up reel 30 can be repackaged in different form at a folding station generally designated 70. At folding station 70, the take-up reel 30 can be disposed on a removable reel axis 72 so that the plurality of connectors 12 and the flexible polymeric
sheet material 14 can be draped over movable fold
pins 74 disposed to overlie a rectangular slot 76
in folding station plate 78. The movable fold pins
74 can be moved away from the reel 30 after the
material is draped over the pins 74 at regular time
intervals to fold the substrate assembly upon itself
in a boustrophedon pattern, generally designated
80 in Fig. 2. As shown in Fig. 2 the thus stacked array
of festooned packaged connectors 12 on flexible sheet
material 14 can be suitably packaged in a container,
such as rectangular cardboard box 82. For this purpose,
the substrate is folded so that each layer has a
length approximately equal to the length of the
cardboard box 82.

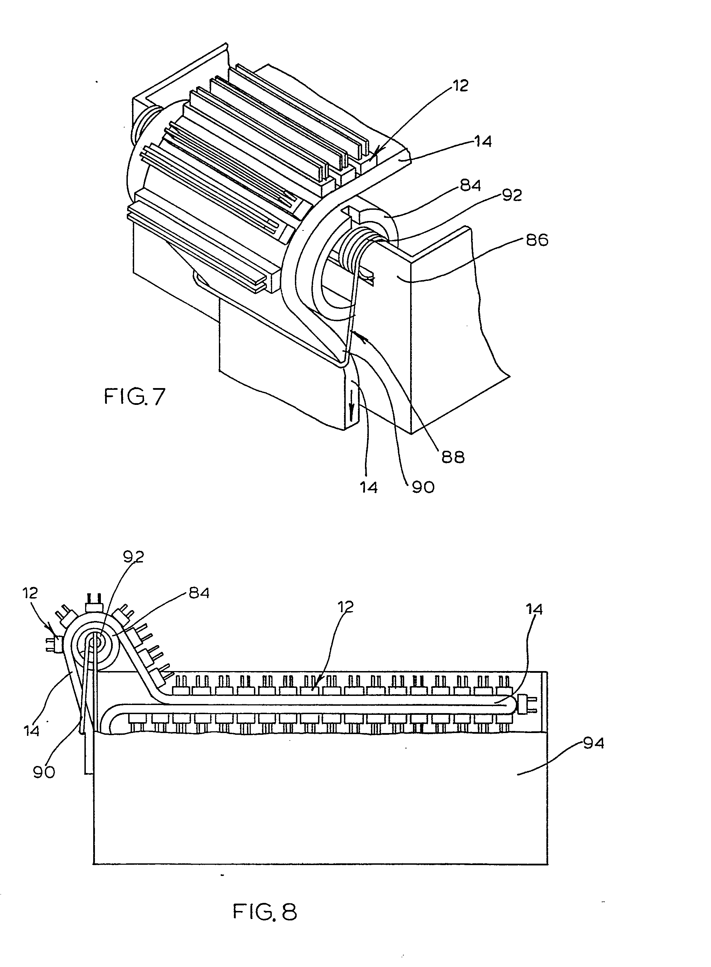

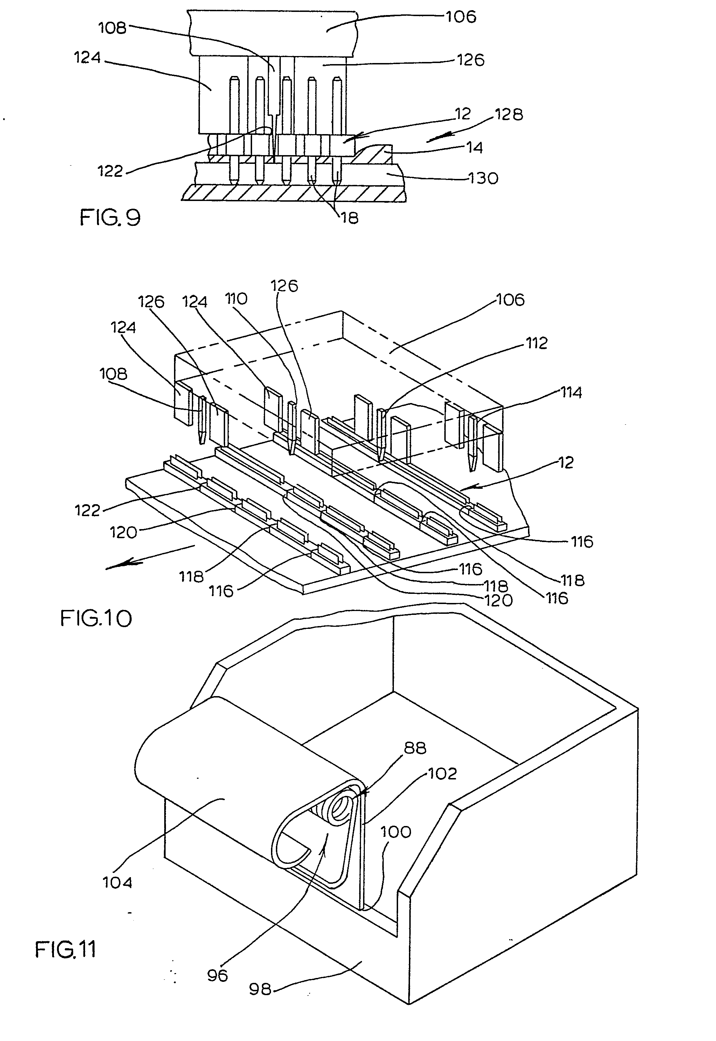

The packaged connectors 12 retained on the
flexible sheet material 14 (see Figs. 7 to 9) can
be disposed at a predetermined disposition relative
to a work station by positioning the flexible substrate
assembly over a roller 84 or an L-shaped assembly
support lip 96 (see Fig. 11) connected to a suitable
substrate assembly container, e.g. a plastics or
cardboard hopper 86 (Figs. 8 and 9) or 98 (Fig. 11),
so that each individual connector 12 can be sequentially
disposed at a predetermined location or work station in an exposed manner overlying the roller 84, or sheet material support lip 96, for individual removal from the polymeric sheet material 14. The assembly support lip or platform 96 is L-shaped including a vertical arm portion 102 and a perpendicular, integral leg or lip portion 104. The assembly support lip 96 is retained in a slot 100 in the hopper 98, as shown in Fig. 11. A substrate assembly retained in the hopper 98 is draped over the extending leg portion 104 to position a connector at a predetermined location on the lip 96. The substrate assembly is moved with respect to the lip 96 after removal of each connector 12 to position another connector 12 at the proper location on the lip 96. In this manner, each individual connector 12 can be removed automatically, such as by a robot arm, and the polymeric sheet material can be moved downwardly, as shown in Fig. 7, to position a next adjacent connector 12 sequentially at the predetermined disposition with respect to the work station for automatic removal, such as by a robot arm.

The roller 84 and sheet material support lip 96 are associated with a sheet material hold-down spring 88 to stabilize the polymeric material 14 against movement away from the roller 84 or lip 96 during removal of a connector 12 from the polymeric material 14. The hold-down spring 88 generally comprises a U-shaped wire member 90 integral with coil spring 92 to bias the U-shaped wire member 90 against the polymeric sheet material 14 in a direction toward the hopper 86 or 98 to hold the polymeric sheet material 14 against the hopper during removal of a connector 12 from the polymeric sheet material 14.

As shown in Fig. 8, the roller 84 can be suitably attached to a package 94 such as a rectangular cardboard box for removal of a stacked array of the substrate assembly in a boustrophedon pattern.

As shown in Figs. 9 and 10, connectors 12 can be cut into a plurality of smaller connectors while the connectors 12 are retained on the flexible polymeric sheet material 14. A cutting blade support plate 106 is provided with a plurality of cutting blades 108, 110, 112 and 114, spaced from each other both longitudinally and transversely so that four transversely spaced connectors 12 can be cut simultaneously to provide a first transverse cut 116 at different longitudinal dispositions in each connector 12. To achieve the full advantage of the cutting, each connector 12 is cut at only one location at a time to prevent the connector 12 from being stressed between simultaneous, multiple spaced cutting blades. As the sheet material 14 and retained connectors 12 are moved in a direction of the arrow as shown in Fig. 10, each time the cutting blade support plate 106 is moved downwardly for cutting, each connector 12 will receive another cut at a different longitudinal location. In the embodiment shown in Fig. 10, each connector 12 is cut at four longitudinal locations: at 116, 118, 120 and 122 step-wise, when the flexible sheet material 14 is moved the transverse spacing distance between connectors and the blades are lowered. After each cut, the flexible sheet material again is advanced a distance equal to the transverse spacing between adjacent rows of connectors 12.

As shown in Fig. 10, each cutting blade 108, 110, 112 and 114 is associated with a pair of alignment blocks 124 and 126 longitudinally aligned with each cutting blade, one on each side thereof. The alignment blocks 124 and 126 are adapted to fit between the pins 18 of the connectors to hold the connectors substantially vertical during cutting, as shown in Fig. 9. As shown in Fig. 9, the polymeric sheet material and retained connectors are positioned for cutting at a cutting station, generally designated 128. A pin receiving material or air space 130 is disposed under the polymeric sheet material 14 to receive the extending pin conductors 18. During connector cutting, the pins 18 are forced downwardly through the polymeric sheet material 14 because of the downward force on the connectors 12 from the cutting blades 108, 110, 112 and 114 and alignment plates 124 and 126. The pin receiving material or air space 130 prevents the pins 18 from being damaged when connectors 12 are cut.

CLAIMS:

1.  A method of removably retaining a plurality of solid members (12) having extending rigid projections (18) in a predetermined disposition on a flexible support substrate (14) characterized by

disposing one of said solid members (12) in juxtaposition to said support substrate (14) such that said projections (18) of said one solid member extend toward a surface of said substrate;

forcing said one solid member toward said substrate surface to insert said projections into said substrate surface thereby forming projection retaining apertures in said substrate surface defined by a substrate surface configuration surrounding said inserted projections, and to removably retain said one solid member on said substrate;

disposing another of said solid members (12) in juxtaposition to said substrate (14) such that said projections of said another solid member extend toward said substrate; and

forcing said another solid member toward said substrate to contact said substrate surface with said projections of said another solid member to insert said projections of said another solid member into said substrate surface and to removably retain said another solid member on said substrate

0158437

- 30 -

at a predetermined location with respect to said one solid member.

2. A method of manufacturing a flexible substrate assembly, said assembly including a plurality of solid members (12), each solid member having a plurality of spaced apart rigid pin-like projections (18) extending therefrom, mounted on a flexible support substrate (14), said method characterized by the steps of:

(a) disposing a portion of said substrate (14) in a generally flat configuration at a work station (22);

(b) disposing one of said solid members (12) in juxtaposition to said flat substrate portion (14) at said work station (22) such that the projections (18) of said solid member extend toward said substrate (14);

(c) moving said solid member (12) with respect to said flat substrate portion at the work station so that said projections penetrate the substrate to removably mount said solid member therein;

(d) moving said substrate (14) so that said mounted solid member is moved away from said work station and another flat substrate portion is provided thereat;

(e) disposing another solid member (12) at said work station as set forth in step (b) above;

(f) moving said another solid member (12) with respect to said another flat substrate portion as set forth in step (c) above;

(g) repeating steps (d), (e) and (f) until a desired number of solid members (12) have been mounted on said substrate (14).

3. The method of claim 1 or 2 wherein said solid members (12) comprise electrical connectors and wherein said extending rigid projections (18) comprise metal electrical conductors.

4. The method of any preceding claim wherein said solid members are inserted into said flexible substrate such that longitudinal axes of adjacent solid members are disposed substantially parallel.

5. The method of any preceding claim wherein a first plurality of said solid members are inserted into said flexible substrate in longitudinal alignment and a second plurality of said solid members are inserted into said flexible substrate in a disposition transversely spaced from said first plurality of solid members.

6. The method of any preceding claim including bending said flexible substrate (14)

0158437

- 32 -

assembly to stack a solid member retained in said flexible substrate above another solid member retained in said flexible substrate to provide a plurality of solid members removably retained on a continuous flexible substrate in a stacked array.

7. The method of any preceding claim including maintaining said solid members in substantially perpendicular alignment to said support substrate during said mounting step.

8. A method of packaging a plurality of electrical connectors (12) in a stacked array, each connector having an insulative housing (16) and a plurality of rigid electrical conductors (18) extending outwardly from said housing characterized by

disposing one of said electrical connectors in juxtaposition to a flexible support substrate (14) such that said conductors of said one electrical connector are essentially perpendicular to a surface of said flexible substrate;

moving said one electrical connector with respect to said substrate surface to insert said conductors into said substrate surface to removably retain said one electrical connector on said substrate;

disposing another of said electrical connectors (12) in juxtaposition to said substrate such that said conductors (18) of said another electrical connector are essentially perpendicular to said substrate surface;

moving said another electrical connector with respect to said substrate to insert said conductors of said another electrical connector into said substrate surface to removably retain said another electrical connector on said substrate at a predetermined location with respect to said one electrical connector; and

bending the flexible substrate (14) having said electrical connectors removably retained thereon to stack a connector retained in said flexible substrate above another connector retained in said flexible substrate to provide a plurality of connectors removably retained on said flexible substrate in a stacked array.

9. The method of claim 8 wherein the connectors retained on the flexible substrate are stacked by winding the substrate and retained connectors upon each other in reel form to provide an annular array of connectors retained in and spaced by said flexible substrate.

10. The method of claim 8 including folding the substrate and retained solid members in a boustrophedon pattern to stack the connectors retained on the substrate.

11. The method of claim 10 including spacing said connectors on said flexible substrate such that said substrate can be festooned and folded to provide an intermediate layer of flexible substrate between adjacent stacked layers of connectors.

12. The method of claim 8 including disposing a plurality of said arrays of substrate retained connectors in a container for transport.

13. The method of any preceding claim 11 to 12 wherein said plurality of solid members are inserted into said flexible substrate such that longitudinal axes of adjacent solid members are disposed substantially parallel.

14. The method of any preceding claim 11 to 13 including maintaining said one solid member in substantially perpendicular alignment to said support substrate while inserting the projections of said another solid member into said support substrate.

15. The method of any preceding claim including disposing said solid member in juxtaposition to said support substrate while retaining the solid member against a stop wall to prevent insertion of the projections, and then removing the stop wall to permit insertion of said projections of said solid member into the support substrate.

16. The method of any preceding claim wherein said solid members are inserted into said support substrate automatically and the support substrate is moved a predetermined distance for insertion of each subsequent solid member to position the solid members in a predetermined spaced relation one to another on the substrate.

17. The method of any preceding claim wherein said flexible support substrate comprises a polymeric foam material having a thickness of about 1/32 inch to about 1/2 inch.

18. A flexible substrate assembly comprising an elongated sheet of flexible, penetrable substrate material (14); and

a plurality of solid members (12), each solid member having a plurality of spaced-apart, pin-like projections (18) extending therefrom, the projections of each solid member penetrating and being removably retained in said sheet material (14), said solid members being mounted on said sheet material in a regular configuration.

19. The substrate assembly of claim 18 wherein said solid members comprise electrical connectors and wherein said extending projections comprise metal electrical conductors.

20. The substrate assembly of claim 18 or 19 wherein said plurality of solid members penetrate said substrate material such that longitudinal axes of adjacent solid members (12) are disposed substantially parallel.

21. The substrate assembly of claim 18, 19 or 20 wherein a first plurality of said solid members penetrate said substrate material in longitudinal alignment and a second plurality of said solid members penetrate said substrate material in a disposition transversely spaced from said first plurality of solid members.

22. The substrate assembly of any preceding claim 18 to 21 wherein said substrate material having said solid members removably retained thereon is bent to stack a solid member retained in said carrier material above another solid member retained in said carrier material in a boustrophedon pattern (80) to provide a plurality of solid members removably retained on a continuous sheet of flexible substrate in a stacked array.

23. The substrate assembly of any preceding claim 18 to 21 wherein the solid members retained on

0158437

- 37 -

the flexible sheet material are wound on a reel (30) to stack the substrate retained solid members one upon another spaced by an intermediate layer of flexible sheet material.

24.  The substrate assembly of any preceding claim 18 to 22 wherein the substrate material is folded upon itself in a boustrophedon pattern (80) to stack the substrate assembly in a folded array.

25.  The substrate assembly of any preceding claim 18 to 24 wherein the flexible substrate material comprises a polymeric material preferably a polyolefin, and more preferably a foamed polyolefin.

26.  An apparatus for producing a flexible substrate assembly, said substrate assembly including

an elongated sheet of flexible, penetrable material (14);

a plurality of solid members (12) with a plurality of spaced-apart, parallel pin-like projections (18) extending therefrom, the projections of each solid member penetrating and removably retained in sid sheet material, said apparatus being characterized by

a work station (22) whereat a solid member is mounted on the sheet material;

means (24) for providing a continuous source of said sheet material to said work station;

means (30) for moving the sheet material longitudinally with respect to the work station to sequentially dispose a different portion of the sheet material at said work station;

component loading means (20) for presenting a plurality of solid members one at a time to the work station so that the projections extend toward said sheet material; and

moving means (32, 34, 36, 40, 42) actuable to move a solid member with respect to the sheet material so that the projections penetrate said sheet material whereby said solid member is removably retained thereon.

27. The apparatus of claim 26 including a stop member (58) disposed at said work station whereby said component loading means moves the solid member against said stop means to position the solid members, one at a time, in juxaposition to said sheet material; and

wherein said moving means for achieving projection penetration comprises a reciprocable elongated insertion plate (46) disposed to contact a solid member positioned at the work station and force the solid member toward said sheet material to insert the extending projections of said solid member into the sheet material,

said insertion plate being adapted to be received between two elongated parallel rows of solid member projections (18) to maintain the projections of said solid member essentially perpendicular to said sheet material during insertion.

28. The apparatus of claim 26 or 27 further including alignment means (48) for maintaining an inserted solid member substantially perpendicular to the sheet material during insertion of an adjacent solid member, said alignment means comprising a pair of elongated, spaced plates (48) adapted to receive therebetween the extending projections of the inserted solid member during insertion of said adjacent solid member.

29. The apparatus of any preceding claim 26 to 28 wherein said work station includes means (56, 58) defining an elongated housing receiving support slot (60) for positioning a solid member in juxtaposition to said sheet material such that said extending projections are substantially perpendicular to said sheet material when said solid member is disposed within said slot defining means (56, 58), said slot defining means including a reciprocable member (58) reciprocable from a first position contacting said solid member to prevent the projections of said solid member from contacting said sheet material to a second position spaced from said solid member to permit the projections of said solid member to be forced into said sheet material.

30. A method of manufacturing a plurality of electrical connectors (12) of predetermined length from at least one longer electrical connector (12) having a plurality of rigid conductors extending therefrom characterized by

disposing said longer electrical connector (12) in juxtaposition to a flexible support substrate (14) such that said conductors (18) of said longer connector are essentially perpendicular to a surface of said flexible substrate;

forcing said longer electrical conductor toward said substrate surface to insert said conductors into said substrate surface and to removably retain said longer electrical connector on said substrate;

cutting said longer electrical connector (12), while said longer electrical connector is retained on said substrate (14), to form a plurality of electrical connectors (12) of predetermined length, each of said plurality of connectors having a plurality of extending conductors (18) inserted in said substrate surface.

31. The method of claim 30 including cutting said longer-electrical connector or connectors (12)

0158437

- 41 -

in a direction transverse to a longitudinal axis
thereof, in a plurality of locations (116, 118, 120,
122) the cuts being made sequentially so that the
or each longer electrical connector is not cut twice
at the same time.

32. The method of any preceding claim
including disposing a plurality of longer electrical
connectors (12) in juxtaposition to said substrate
(14) and forcing said plurality of electrical
connectors toward said substrate to insert said
conductors of said plurality of electrical connectors
into said substrate at a predetermined spacing between
adjacent longer electrical connectors and cutting
a plurality of said longer electrical connectors
into smaller electrical connectors by cutting said
plurality of longer electrical connectors simultaneously.

33. The method of claim 32 including cutting
said plurality of longer electrical connectors with
a cutting means (106, 108, 110, 112 and 114) having
a plurality of blades (108, 110, 112, 114) spaced
from each other both longitudinally and transversely
to provide a single cut in each longer electrical
connector while cutting a plurality of said longer
electrical connectors simultaneously.

34. The method of claim 33 including conveying said plurality of longer electrical connectors and said flexible substrate step-wise in a direction transverse to the longitudinal axes of said longer electrical connectors to dispose each of said longer electrical connectors in alignment with the cutting means.

35. A method of producing a packaging arrangement, said packaging arrangement including a plurality of solid members (12) received within a container (82), each solid member having a plurality of spaced-apart, parallel pin-like projections (18) extending therefrom, said method being characterized by the steps of

(a) providing a substrate assembly including an elongated sheet of flexible, foldable, penetrable material (14) having the projections (18) of each solid member (12) extending into and removably retained in said sheet material so that the solid members are mounted on said sheet material in a regular configuration;

(b) providing the container (82) with a substrate assembly receiving opening;

(c) layering said substrate assembly upon itself into the container by winding or folding the substrate assembly to form layers; and

(d) covering said substrate receiving opening in said container for transport.

36. A packaging arrangement containing at least one substrate assembly (80) including a plurality of solid members (12) removably retained on a sheet of flexible support material (14) characterized by the or each

substrate assembly (80) including an elongated sheet of flexible material (14) having removably retained therein in a predetermined disposition, one to another, a plurality of solid members (12) having extending rigid projections (18), said projections extending into and removable from said flexible sheet material; and

means (82) for containing said substrate assembly or assemblies, said containing means being disposed to surround said substrate assembly or assemblies for transport.

37. The package of claim 36 wherein said flexible sheet material comprises a plurality of film or sheet layers contacting said rigid projections at at plurality of spaced locations to prevent said solid members from inadvertent removal from said sheet material when said sheet material is moved.

38. The package of claim 36 wherein said plurality of film or sheet layers comprise gaseously spaced layers of foamed polymeric material.

39. The packaging arrangement of claim 36, 37 or 38 wherein said plurality of solid members penetrate said substrate material such that longitudinal axes of adjacent solid members are disposed substantially parallel.

40. The packaging arrangement of any preceding claim 36 to 39 wherein the substrate material comprises a flexible polymeric material preferably a polyolefin and more preferably a foamed polyolefin.

41. An apparatus for producing a packaging arrangement comprising a substrate assembly including an elongated sheet of flexible, foldable material (14) having a plurality of solid members (12) mounted thereon in a regular spaced-apart configuration along the length of the sheet, said substrate assembly adapted to be received in a container (82);

said apparatus being characterized by

reel means (30) for storing and presenting the substrate assembly;

means (70) for paying out a predetermined length of said substrate assembly from said reel means, said length being equal to or less than the length of said container and defining a layer; and

layering means (74, 76) for disposing a plurality of layers of said substrate assembly in a boustrophedon configuration (80), said layers being disposed generally parallel to one another.

42. The apparatus of claim 41 further including means for manufacturing said substrate assembly, said substrate assembly manufacturing means being characterized by

a work station (22) whereat a solid member (12) is mounted on the sheet material (14);

means (24) for providing a continuous source of said sheet material to said work station;

means (30) for moving the sheet material longitudinally with respect to the work station to sequentially dispose a different portion of the sheet material at said work station;

component loading means (20) for presenting a plurality of solid members (12) one at a time to the work station so that the projections (18) extend toward said sheet material;

moving means (32, 34, 36, 40, 42) actuable to move a solid member with respect to the sheet material so that the projections penetrate said sheet material whereby said solid member is removably retained thereon;

and reel means (30) for collecting the completed substrate assembly, said layering means (70) including a generally flat plate (78) having walls defining an aperture (76) therein

a reel of said substrate assembly being disposed to pay out a length of substrate assembly to said aperture (76); and

a plurality of substrate contacting elongated pins (74) being provided extending over the aperture for sequentially contacting the substrate to form a plurality of folds in said substrate assembly to fold the substrate assembly in a boustrophedon pattern (80).

43. A method of dispensing solid members from a packaging arrangement (86 or 94), said packaging arrangement including

a container (86 or 94) having an opening with a dispensing lip (84 or 96) along one edge thereof;

a substrate assembly received in said container, said substrate assembly including an elongated sheet of flexible, penetrable material (14) having a plurality of solid members (12) removably mounted thereon in a regular spaced-apart configuration along the length of the sheet, said substrate assembly being layered upon itself to define a plurality of substrate assembly layers within the container (86 or 94), the method being characterized by the steps of

(a) disposing the substrate assembly in forceful contact over the dispensing lip (84 or 96) so that a first solid member (12) is presented at a predetermined position on the dispensing lip;

(b) removing said first solid member from the sheet material (14);

(c) moving the substrate assembly with respect to said dispensing lip until a second solid member (12) is disposed at said predetermined position in forceful contact over the dispensing lip (84 or 96);

(d) removing the second solid member from the sheet material; and

(e) repeating steps (b) and (c) until a desired number of solid members have been removed from the sheet material.

44. Apparatus for sequentially disposing a plurality of solid members, one at a time at a predetermined disposition relative to a work station characterized by

housing means (86 or 94) having received therein a substrate assembly in a stacked array, said substrate assembly including a plurality of solid members (12) removably retained in a flexible sheet material (14), said solid members having extending rigid projections (18) inserted into said flexible sheet material (14);

a sheet material supporting means (84 or 96) extending from said housing means, said supporting means having a first portion (102) contacting said housing means and a second portion (104) disposed at said work station;

said substrate assembly being disposed to overlie the sheet material supporting means (84 or 96) to dispose a first solid member at a predetermined position on the supporting means;

and sheet material holding means (88 or 92) for holding the sheet material (14) on said supporting means (84 or 96) when a solid member is removed therefrom.

FIG.1

FIG. 2

0158437

FIG 3

FIG. 4

FIG. 5

FIG. 6

FIG. 7

FIG. 8

FIG.9

FIG.10

FIG.11